# EUROPÄISCHE PATENTANMELDUNG

(11) **EP 4 489 054 A1**
(43) Veröffentlichungstag der Anmeldung: **08.01.2025**
(21) Anmeldenummer: 24185943.8
(22) Anmeldetag: 02.07.2024
(51) Int. Cl.: H01L 21/04, H01L 21/265

(54) **VERFAHREN ZUR IMPLANTATION**

(30) Priorität: 03.07.2023 DE 102023206269
(71) Anmelder: Fraunhofer-Gesellschaft zur Förderung der angewandten Forschung e.V., 80686 München (DE)
(72) Erfinder: Giese, Christian, 79108 Freiburg (DE)
(74) Vertreter: Friese Goeden Patentanwälte PartGmbB

(57) **Zusammenfassung**

Die Erfindung betrifft ein Verfahren zur Implantation, enthaltend die folgenden Schritte: Bereitstellen eines Substrates (1), welches Diamant enthält oder daraus besteht; Erzeugen zumindest einer erhabenen Struktur (2) auf dem Substrat (1); Implantieren eines Dotierstoffes zumindest in einen Teilbereich (25) der erhabenen Struktur (2), wobei der zur Implantation verwendete Ionenstrahl (3) unter einem Winkel von etwa 80° bis etwa 90° zum Normalenvektor (5) des Substrates (1) einfällt.

## Beschreibung

Die Erfindung betrifft ein Verfahren zur Implantation, enthaltend die folgenden Schritte: Bereitstellen eines Substrates, welches ein Halbleitermaterial enthält oder daraus besteht, Erzeugen zumindest einer erhabenen Struktur auf dem Substrat und Implantieren eines Dotierstoffes zumindest in einem Teilbereich der erhabenen Struktur.

Aus P. Maletinsky, S. Hong, M. Grinolds, B. Hausmann, M. Lukin, R. Walsworth, M. Loncar, A. Yacoby: "A robust scanning diamond sensor for nanoscale imaging with single nitrogen-vacancy centres", Nature nanotechnology 7 (2012) 320 ist bekannt, Farbzentren in halbleitendem Diamant zu erzeugen. Ein solches Farbzentrum kann beispielsweise ein NV-Zentrum sein. Dieses besteht aus einem Stickstoffatom und einer benachbarten Leerstelle des Kristallgitters des Diamant. NV-Zentren können beispielsweise zur Bestimmung der Stärke eines magnetischen Feldes eingesetzt werden. Hierzu wird die Aufspaltung eines Dublett-Zustandes im magnetischen Feld durch spektroskopische Messung erfasst. Sofern ein oder wenige NV-Zentren in einem kleinen Teilvolumen des Diamant konzentriert sind, kann die Bestimmung des Magnetfeldes mit hoher räumlicher Auflösung erfasst werden, beispielsweise weniger als 1 um oder weniger als 100 nm. Darüber hinaus können NV-Zentren in der Quanteninformationstechnik als Q-Bit verwendet werden.

Diese bekannten Anwendungen von Farbzentren setzen voraus, dass Farbzentren in einem kleinen, definierten Volumen eines größeren Halbleiterbauelementes erzeugt werden können. Nach dem Stand der Technik erfolgt dies in der Regel durch Implantation mit einem fokussierten Ionenstrahl oder nach Aufbringen einer Hartmaske, wobei der Ionenstrahl entlang des Normalenvektors des Halbleitersubstrates auftrifft und die Ionen in die unmaskierten Teilflächen implantiert werden können. Dieses Verfahren weist jedoch den Nachteil auf, dass die Herstellung kleinster Öffnungen in der Hartmaske mit hohem Aufwand verbunden ist.

Ausgehend vom Stand der Technik liegt die Erfindung in einem möglichen Aspekt die Aufgabe zugrunde, ein Verfahren anzugeben, mit welchem die Implantation einfach und zuverlässig in eng begrenzte Raumbereiche erfolgen kann.

Gemäß einem Aspekt der Erfindung kann ein Verfahren mit folgenden Schritten durchgeführt werden: Zunächst wird ein Substrat bereitgestellt, welches ein Halbleitermaterial enthalten oder daraus bestehen kann. Das Halbleitermaterial kann beispielsweise Silizium, Germanium, ein III-V-Verbindungshalbleiter, ein Gruppe-III-Nitrid oder Diamant enthalten oder daraus bestehen. Das Halbleitermaterial kann als Dünnschicht auf einem Trägermaterial angeordnet sein. In anderen Ausführungsformen der Erfindung kann das Substrat vollständig aus dem Halbleitermaterial bestehen. Das Substrat kann darüber hinaus beschichtet sein und/oder einen Dotierstoff enthalten, um eine vorgebbare Leitfähigkeit des Substrates zu ermöglichen.

Auf dem Substrat kann in einigen Ausführungsformen der Erfindung zumindest eine erhabene Struktur erzeugt werden . Die erhabene Struktur kann beispielsweise ein MESA oder ein Cantilever sein. Diese Strukturen können in an sich bekannter Weise durch Maskieren und Ätzen des Substrates erhalten werden. In anderen Ausführungsformen der Erfindung können die erhabenen Strukturen durch Maskieren und Abscheiden weiterer Schichten auf dem Substrat erzeugt werden, beispielsweise mittels MBE oder MOCVD. Die Erfindung lehrt nicht die Verwendung einer bestimmten Struktur als Lösungsprinzip. Die Struktur ist jedoch erhaben im Sinne der vorliegenden Beschreibung, wenn diese zumindest teilweise über eine durch die Substratoberfläche definierte Ebene hinausragt. Die erhabene Struktur enthält zumindest ein Halbleitermaterial. Dabei kann es sich um das Material des Substrates handeln oder ein weiteres Material.

Das Verfahren kann weiterhin zumindest einen Verfahrensschritt einer Implantation eines Dotierstoffes umfassen. Der Dotierstoff kann in einigen Ausführungsformen der Erfindung dazu eingesetzt werden, eine vorgebbare Leitfähigkeit des Halbleitermaterials in zumindest einem Teilbereich bzw. einem Teilvolumen zu erzeugen. In anderen Ausführungsformen der Erfindung kann der Dotierstoff zumindest ein Farbzentrum im Kristallgitter des Halbleitermaterials des Substrates bilden. Unter einem Dotierstoff kann insoweit zumindest ein Fremdatom verstanden werden. Der Dotierstoff kann durch Implantation eingebracht werden, d. h. indem der Dotierstoff ionisiert und mittels elektrischer Felder auf eine vorgebbare kinetische Energie beschleunigt und auf das Substrat gerichtet wird.

Gemäß einem Aspekt der vorliegenden Offenbarung wird vorgeschlagen, dass der zur Implantation verwendete Ionenstrahl unter einem Winkel von etwa 80° bis etwa 90° zum Normalenvektor des Substrates einfällt. Anders als bei bekannten Implantationsverfahren, bei welchen der Ionenstrahl in etwa parallel zum Normalenvektor auf das Substrat gerichtet ist, wird hier somit vorgeschlagen, dass zwischen dem Normalenvektor und der Einfallsrichtung des Ionenstrahls in etwa ein rechter Winkel vorliegt. Dieses Merkmal hat die Wirkung, dass die Ionen in die Stirnseiten oder Spitzen der erhabenen Strukturen implantiert werden können. Das Volumen des implantierten Bereiches wird in diesem Fall durch die Eindringtiefe und die Querschnittsfläche der Stirnfläche definiert. Auf diese Weise können auch sehr kleine Teilvolumina der erhabenen Struktur implantiert werden, ohne dass aufwendige und vergleichsweise dicke Masken auf dem Substrat bzw. den erhabenen Strukturen abgeschieden werden müssen.

Sofern der Winkel zwischen der Einfallsrichtung und dem Normalenvektor etwas geringer ist als 90°, kann auch in mehrere auf dem Substrat angeordnete erhabenen Strukturen implantiert werden. Hierdurch kann die Produktivität des vorgeschlagenen Verfahrens weiter erhöht werden.

In einigen Ausführungsformen der Erfindung kann der zur Implantation verwendete Ionenstrahl unter einem Winkel von etwa 85° bis etwa 90° zum Normalenvektor des Substrates einfallen. In anderen Ausführungsformen der Erfindung kann der zur Implantation verwendete Ionenstrahl unter einem Winkel von etwa 84° bis etwa 89° zum Normalenvektor des Substrates einfallen. In wiederum anderen Ausführungsformen der Erfindung kann der zur Implantation verwendete Ionenstrahl unter einem Winkel von etwa 85° bis etwa 88° zum Normalenvektor des Substrates einfallen. In einigen Ausführungsformen der Erfindung kann der zur Implantation verwendete Ionenstrahl unter einem Winkel von etwa 88° bis etwa 89° zum Normalenvektor des Substrates einfallen. In diesen Winkelbereichen können sich die erhabenen Strukturen zumindest teilweise selbst oder auch gegenseitig abschatten, sodass das in jeder erhabenen Struktur ungeachtet deren Ausdehnung auf der Substratoberfläche nur Teilbereiche implantiert werden. Gleichzeitig können die gesamten auf der Oberfläche angeordneten erhabenen Strukturen auch großer Substrate in nur einem Arbeitsschritt implantiert werden, sodass mit dem Verfahren auch große Stückzahlen von Halbleiterbauelementen auch in kurzer Zeit hergestellt werden können.

In einigen Ausführungsformen der Erfindung kann der zur Implantation verwendete Ionenstrahl eine Energie von etwa 5 keV bis etwa 1 MeV aufweisen. In anderen Ausführungsformen der Erfindung kann der zur Implantation verwendete Ionenstrahl eine Energie von etwa 20 keV bis etwa 100 keV aufweisen. In wiederum anderen Ausführungsformen der Erfindung kann der zur Implantation verwendete Ionenstrahl eine Energie von etwa 20 keV bis etwa 50 keV aufweisen. In nochmals anderen Ausführungsformen der Erfindung kann der zur Implantation verwendete Ionenstrahl eine Energie von etwa 5 keV bis etwa 20 keV oder von etwa 5 keV bis etwa 15 keV aufweisen.

In einigen Ausführungsformen der Erfindung kann der zur Implantation verwendete Ionenstrahl Stickstoff und/oder Silizium und/oder Germanium und/oder Blei und/oder Zinn enthalten. Diese Materialien erlauben die Herstellung von Farbzentren insbesondere in Diamant. Diese können in der Quantentechnologie vielfältig eingesetzt werden, beispielsweise im Quantencomputing, zur Quantenkommunikation oder zur Erfassung elektrischer oder magnetischer Felder. In diesem Fall kann die Energie des Ionenstrahls so gewählt sein, dass die Ionen zumindest teilweise im Diamant implantiert werden, auch wenn dieser nur als Schicht auf einem Substrat aus einem anderen Material angeordnet ist.

In einigen Ausführungsformen der Erfindung kann der zur Implantation verwendete Ionenstrahl Stickstoff und/oder Bor und/oder Schwefel und/oder Phosphor und/oder Aluminium enthalten oder daraus bestehen. Diese Materialien können als Donor oder Akzeptor eingesetzt werden und erlauben somit, die Leitfähigkeit des Substrates bzw. der implantierten Teilvolumina auf vorgebbare Zielwerte einzustellen.

In einigen Ausführungsformen der Erfindung kann der zur Implantation verwendete Ionenstrahl kollimiert sein. Hierdurch wird einerseits die Winkeldivergenz reduziert, sodass die unkontrollierte Implantation der Dotierstoffe reduziert oder vermieden wird. Darüber hinaus kann ein kollimierter Strahl eine größere Fläche auf dem Substrat erfassen, sodass eine Vielzahl von erhabenen Strukturen gleichzeitig implantiert werden kann.

In einigen Ausführungsformen der Erfindung können eine Mehrzahl erhabener Strukturen in Einfallsrichtung des Ionenstrahls hintereinander erzeugt werden. Dies erlaubt die bessere Ausnutzung des Halbleitermaterials des Substrates. In einigen Ausführungsformen der Erfindung kann eine Teilfläche einer ersten erhabenen Struktur eine Teilfläche einer zweiten erhabenen Struktur gegen den einfallenden Ionenstrahl abschatten. Hierzu kann die zweite erhabene Struktur in Einfallsrichtung des Ionenstrahles gesehen hinter der ersten erhabenen Struktur liegen. Aufgrund der Selbstabschattung einer Mehrzahl von Bauelementen können über die gesamte Oberfläche des Substrates gezielt Teilbereiche bzw. Teilvolumina der erhabenen Strukturen implantiert werden, ohne dass aufwendige Hartmasken auf dem Substrat erzeugt und strukturiert werden müssen.

In einigen Ausführungsformen der Erfindung kann die dem Substrat abgewandte Oberseite der erhabenen Struktur zumindest teilweise mit einer Maske versehen sein. In einigen Ausführungsformen der Erfindung kann diese Maske auch während zumindest eines Fertigungsschrittes bei der Erzeugung zumindest einer erhabenen Struktur Verwendung finden und nach dem Erzeugen der erhabenen Struktur zunächst auf dieser verbleiben und nach der Implantation optional entfernt werden. Aufgrund des streifenden Einfalles des zur Implantation verwendeten Ionenstrahles reicht in diesem Fall eine dünne Maske von beispielsweise 10 nm bis etwa 100 nm aus, um das Eindringen der zur Implantation verwendeten Ionen in die maskierten Bereiche zu vermeiden.

In einigen Ausführungsformen der Erfindung kann das Verfahren den zusätzlichen Verfahrensschritt enthalten, auf der ersten Seite des Substrates zumindest eine erhabene Barriere zu erzeugen. Auch die Barriere kann beispielsweise durch Maskieren und Ätzen oder durch Abscheiden zusätzlichen Materials auf dem Substrat erzeugt werden. In einigen Ausführungsformen der Erfindung kann die Barriere eine Ausnehmung enthalten. Die Längsausdehnung der Barriere kann dabei in etwa parallel zur Ausdehnung der erhabenen Strukturen verlaufen. Die Barriere kann beabstandet zu den erhabenen Strukturen bzw. beabstandet zu einer erhabenen Struktur erzeugt werden. Die Barriere steht somit nach Art einer Mauer auf dem Substrat und ist nicht flächig in der Ebene des Substrates abgeschieden. Dieses Merkmal hat die Wirkung, dass die Implantation durch die Barriere hindurch bzw. durch die in der Barriere erzeugte Ausnehmung hindurch erfolgen kann und auf diese Weise räumlich begrenzt bleibt. Auch in diesem Fall erfolgt die Implantation jedoch in etwa orthogonal zum Normalenvektor des Substrates und nicht in an sich bekannter Weise parallel zum Normalenvektor.

In einigen Ausführungsformen der Erfindung kann der zur Implantation verwendete Ionenstrahl unter einem Winkel von etwa 45° bis etwa 90° zur Längsausdehnung der erhabenen Struktur und/oder der Barriere einfallen. Kleinere Winkel bewirken dabei eine in der Projektion abnehmende Ausdehnung der Ausnehmung, sodass der Implantationsbereich weiter verkleinert werden kann.

In einigen Ausführungsformen der Erfindung kann der zur Implantation verwendete Ionenstrahl unter einem Winkel von etwa 45° bis etwa 85° zur Längsausdehnung der erhabenen Struktur und/oder der Barriere einfallen. In anderen Ausführungsformen der Erfindung kann der zur Implantation verwendete Ionenstrahl unter einem Winkel von etwa 45° bis etwa 80° zur Längsausdehnung der erhabenen Struktur und/oder der Barriere einfallen. In wiederum anderen Ausführungsformen der Erfindung kann der zur Implantation verwendete Ionenstrahl unter einem Winkel von etwa 60° bis etwa 80° zur Längsausdehnung der erhabenen Struktur und/oder der Barriere einfallen. Hierdurch kann die Größe bzw. das Volumen des zu implantierenden Bereiches der erhabenen Struktur kontrolliert werden.

Nachfolgend soll die Erfindung anhand von Figuren ohne Beschränkung des allgemeinen Erfindungsgedankens näher erläutert werden. Dabei zeigt
- Figur 1: eine erste Ausführungsform des vorgeschlagenen Verfahrens.
- Figur 2: zeigt eine zweite Ausführungsform des vorgeschlagenen Verfahrens.
- Figur 3: zeigt eine dritte Ausführungsform des vorgeschlagenen Verfahrens.

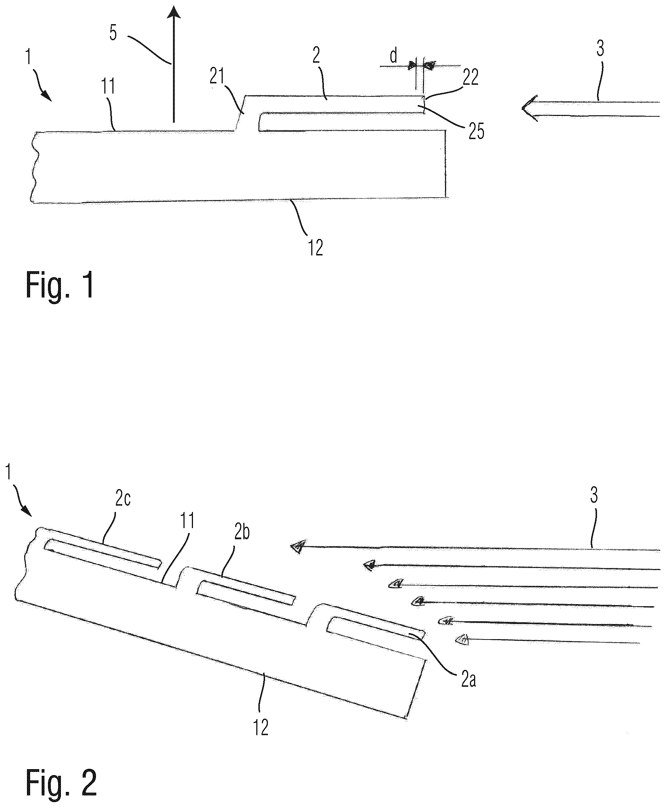

Anhand der Figur 1 wird eine erste Ausführungsform des vorgeschlagenen Verfahrens zur Implantation näher erläutert. Dabei zeigt Figur 1 ein Substrat 1 im Schnitt sowie den zur Implantation verwendeten Ionenstrahl 3.

Figur 1 zeigt ein Substrat 1 mit einer ersten Seite 11 und einer gegenüberliegenden zweiten Seite 12. Dargestellt ist weiterhin der Normalenvektor 5 der durch das Substrat 1 definierten Ebene. Das Substrat 1 kann ein Halbleitermaterial enthalten oder daraus bestehen. Insbesondere kann das Halbleitermaterial ausgewählt sein aus Silizium, einem III-V-Verbindungshalbleiter oder Diamant. Das Substrat 1 kann homogen ausgeführt sein. In anderen Ausführungsformen der Erfindung kann das Substrat 1 eine Beschichtung aufweisen, beispielsweise kann ein III-V-Verbindungshalbleiter auf Saphir abgeschieden sein. In anderen Ausführungsformen der Erfindung kann eine Diamantschicht homoepitaktisch oder heteroepitaktisch auf Diamant bzw. Silizium abgeschieden sein. Das Material des Substrates 1 kann vollständig oder teilweise mit einem Dotierstoff versehen sein.

Wie Figur 1 weiter zeigt, wurde auf dem Substrat 1 eine erhabene Struktur 2 erzeugt. Die erhabene Struktur 2 ist im dargestellten Ausführungsbeispiel ein Kragarm bzw. ein Cantilever mit einem ersten Ende 21 und einem gegenüberliegenden zweiten Ende 22. Der Cantilever verläuft parallel zur ersten Seite 11 des Substrates 1 bzw. liegt innerhalb einer zur Substratebene parallelen Ebene. Das erste Ende 21 ist über einen Verbindungssteg fest mit dem Substrat 1 verbunden. Das gegenüberliegende zweite Ende 22 kragt frei in den an das Substrat 1 angrenzenden Halbraum aus.

Die erhabene Struktur 2 gemäß Figur 1 kann beispielsweise als Wellenleiter ausgeführt sein, welcher Licht vom zweiten Ende 22 zum ersten Ende 21 transportiert. Am zweiten Ende 22 kann ein dotierter Bereich 25 vorhanden sein, welcher zumindest ein oder auch mehrere Farbzentren enthält, beispielsweise NV-Zentren.

Sofern die NV-Zentren zur Bestimmung eines Magnetfeldes eingesetzt werden sollen, wird die räumliche Auflösung dadurch verbessert, dass der dotierte Bereich 25 ein möglichst geringes Volumen der erhabenen Struktur 2 einnimmt. Nach dem Stand der Technik würde dies dadurch erzielt, dass die erste Seite 11 des Substrates 1 mit einer vergleichsweise dicken Hartmaske versehen wird, welche das zweite Ende 22 der erhabenen Struktur 2 freilässt, sodass die zur Herstellung der Farbzentren erforderlichen Fremdatome parallel zum Normalenvektor 5 implantiert werden können.

Im Gegensatz dazu wird erfindungsgemäß vorgeschlagen, dass der zur Implantation verwendete Ionenstrahl 3 unter einem Winkel von etwa 80° bis etwa 90° zum Normalenvektor 5 des Substrates 1 einfällt. Hierdurch wird in Strahlrichtung die zur Implantation zur Verfügung stehende Fläche auf die Querschnittfläche der erhabenen Struktur 2 begrenzt. Die Eindringtiefe d ist durch die kinetische Energie der auftreffenden Ionen limitiert. Hierdurch ergibt sich ein räumlich scharf begrenztes Volumen des implantierten Bereiches 25, ohne dass eine aufwendige Prozessierung durch die Abscheidung, Strukturierung und Entfernung von Hartmasken erforderlich ist. Aus der vorherigen Erzeugung der zumindest einen erhabenen Struktur 2 verbliebene Masken können optional während der Implantation auf der erhabenen Struktur 2 verbleiben. Zwingend erforderlich ist dies jedoch nicht.

Das erfindungsgemäße Verfahren erlaubt eine sehr gute räumliche Lokalisation der dotierten Bereiche 25 mit geringem apparativen Aufwand. Vorteilhaft ist hierzu der verwendete Ionenstrahl 3 kollimiert. Unter einem kollimierten Strahl wird für die Zwecke der vorliegenden Erfindung eine geringe Winkeldivergenz der eintreffenden Ionen verstanden, sodass ein unerwünschtes seitliches Auftreffen der Ionen auf die erhabene Struktur 2 vermieden wird.

Anhand der Figur 2 wird eine zweite Ausführungsform der vorliegenden Erfindung näher erläutert. Gleiche Bestandteile der Erfindung sind mit gleichen Bezugszeichen versehen, sodass sich die nachfolgende Beschreibung auf die wesentlichen Unterschiede beschränkt.

Auch Figur 2 zeigt den Querschnitt durch ein Substrat 1. Wie aus Figur 2 ersichtlich ist, sind mehrere erhabene Strukturen 2a, 2b und 2c in Einfallsrichtung des Ionenstrahls 3 hintereinander auf dem Substrat 1 erzeugt. Dabei ist darauf hinzuweisen, dass die dargestellten drei erhabenen Strukturen lediglich beispielhaft zu verstehen sind. In anderen Ausführungsformen der Erfindung kann die Anzahl auch größer oder geringer sein.

Der Winkel zwischen dem Normalenvektor des Substrates 1 und dem Ionenstrahl 3 ist in Figur 2 zur Verdeutlichung stark vergrößert. Bei realen Ausführungen des Verfahrens läge der Winkel zwischen dem Normalenvektor und dem Ionenstrahl näher bei 90°, um auf diese Weise einen streifenden Einfall der Ionen auf der ersten Seite 11 des Substrates 1 zu ermöglichen. Wie Figur 2 zeigt, führt ein solcher streifender Einfall dazu, dass eine vorne liegende erhabene Struktur 2a die dahinterliegende erhabene Struktur 2b teilweise abschattet. Ebenso wird die erhabene Struktur 2c von der in Einfallsrichtung vor ihr liegenden erhabenen Struktur 2b teilweise abgeschattet. Auf diese Weise können innerhalb der erhabenen Strukturen 2a, 2b und 2c dotierte Bereiche 25 geschaffen werden, ohne dass eine Maskierung zwingend erforderlich ist. Der mit dem Aufbringen einer Maske verbundene Aufwand kann somit eingespart werden. Durch Kippen des Substrates in die eine oder andere Richtung kann die Lage des dotierten Bereiches 25 innerhalb der Längsausdehnung der erhabenen Struktur 2 kontrolliert werden. Der Einfallswinkel des Ionenstrahls 3 wird dabei so gewählt, dass eine unerwünschte Implantation in undotierte Bereiche der erhabenen Strukturen 2a, 2b, 2c vermieden wird, beispielsweise weil die Ionen bei streifenden Einfall die erhabenen Strukturen 2a, 2b, 2c wieder verlassen oder so flach implantiert werden, dass diese Schicht durch nachfolgendes Ätzen entfernt werden kann.

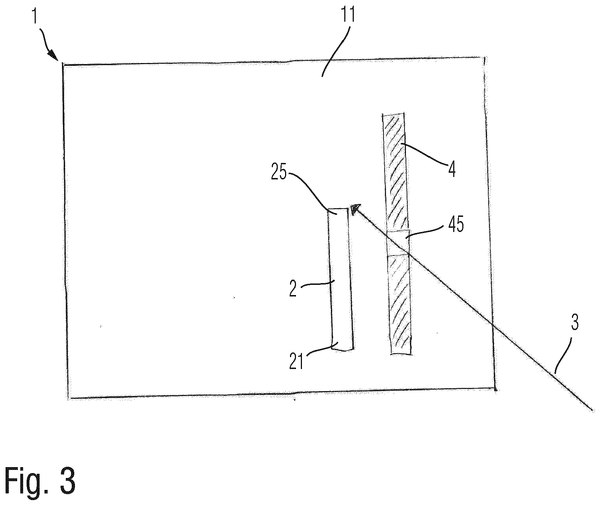

Anhand der Figur 3 wird eine dritte Ausführungsform der Erfindung näher erläutert. Figur 3 zeigt die Aufsicht auf die erste Seite 11 eines Substrates 1. Beispielhaft ist auf dem Substrat 1 eine erhabene Struktur 2 dargestellt. Selbstverständlich kann die Anzahl der erhabenen Strukturen 2 auch größer sein, um auf diese Weise eine Mehrzahl von Bauelementen in einem Arbeitsgang herzustellen.

Auch die erhabene Struktur 2 gemäß Figur 3 weist eine Längsausdehnung mit einem ersten Ende 21 und einem gegenüberliegenden Ende 22 auf. Am zweiten Ende 22 soll ein dotierter Bereich 25 erzeugt werden. Hierzu wird auf der ersten Seite 11 des Substrates 1 parallel und beabstandet zur erhabenen Struktur 2 eine Barriere 4 erzeugt. Die Barriere 4 kann beispielsweise durch Maskieren und Ätzen gleichzeitig mit der erhabenen Struktur 2 hergestellt werden. Innerhalb der Barriere 4 befindet sich eine Ausnehmung 45. Der zur Implantation verwendete Ionenstrahl 3 fällt unter einem Winkel von etwa 45° bis etwa 90° zur Längsausdehnung der Barriere 4 ein und durchdringt teilweise die Ausnehmung 45. Ein anderer Teil der einfallenden Ionen wird in der Barriere 4 gestoppt, sodass dieser Anteil die erhabene Struktur 2 nicht erreicht. Die relative Lage der Ausnehmung 45, deren Breite sowie der Einfallswinkel können so gewählt sein, dass die räumliche Ausdehnung des dotierten Bereiches 45 sowie dessen Lage vorgebbare Werte erreichen.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

## Patentansprüche

1. Verfahren zur Implantation, enthaltend die folgenden Schritte:
Bereitstellen eines Substrates (1), welches Diamant enthält oder daraus besteht;
Erzeugen zumindest einer erhabenen Struktur (2) auf dem Substrat (1);
Implantieren eines Dotierstoffes zumindest in einen Teilbereich (25) der erhabenen Struktur (2);
**dadurch gekennzeichnet, dass**
der zur Implantation verwendete Ionenstrahl (3) unter einem Winkel von etwa 80° bis etwa 90° zum Normalenvektor (5) des Substrates (1) einfällt.

2. Verfahren nach Anspruch 1, **dadurch gekennzeichnet, dass** der zur Implantation verwendete Ionenstrahl (3) kollimiert ist.

3. Verfahren nach einem der Ansprüche 1 oder 2, **dadurch gekennzeichnet, dass** der zur Implantation verwendete Ionenstrahl unter einem Winkel von etwa 85° bis etwa 90° zum Normalenvektor (5) des Substrates (1) einfällt oder
dass der zur Implantation verwendete Ionenstrahl (3) unter einem Winkel von etwa 84° bis etwa 89° zum Normalenvektor (5) des Substrates (1) einfällt oder
dass der zur Implantation verwendete Ionenstrahl (3) unter einem Winkel von etwa 85° bis etwa 88° zum Normalenvektor (5) des Substrates (1) einfällt oder
dass der zur Implantation verwendete Ionenstrahl (3) unter einem Winkel von etwa 88° bis etwa 89° zum Normalenvektor (5) des Substrates (1) einfällt.

4. Verfahren nach einem der Ansprüche 1 bis 3, **dadurch gekennzeichnet, dass** der zur Implantation verwendete Ionenstrahl (3) Stickstoff und/oder Silizium und/oder Germanium und/oder Blei und/oder Zinn und/oder Bor und/oder Schwefel und/oder Phosphor und/oder Aluminium enthält oder daraus besteht.

5. Verfahren nach einem der Ansprüche 1 bis 4, **dadurch gekennzeichnet, dass** die dem Substrat (1) abgewandte Oberseite der erhabenen Struktur (2) zumindest teilweise mit einer Maske versehen ist.

6. Verfahren nach einem der Ansprüche 1 bis 5, **dadurch gekennzeichnet, dass** der zur Implantation verwendete Ionenstrahl (3)
eine Energie von etwa 5 keV bis etwa 1 MeV oder
eine Energie von etwa 20 keV bis etwa 100 keV oder
eine Energie von etwa 20 keV bis etwa 50 keV oder
eine Energie von etwa 5 keV bis etwa 20 keV oder
eine Energie von etwa 5 keV bis etwa 15 keV aufweist.

7. Verfahren nach einem der Ansprüche 1 bis 6, **dadurch gekennzeichnet, dass** eine Mehrzahl erhabener Strukturen (2a, 2b, 2c) in Einfallsrichtung des Ionenstrahles (3) hintereinander erzeugt werden.

8. Verfahren nach Anspruch 7, **dadurch gekennzeichnet, dass** eine Teilfläche einer ersten erhabenen Struktur (2a) eine Teilfläche einer zweiten erhabenen Struktur (2b) gegen den einfallenden Ionanstrahl (3) abschattet.

9. Verfahren nach einem der Ansprüche 1 bis 8, weiterhin enthaltend den Verfahrensschritt des Erzeugens zumindest einer erhabenen Barriere (4) auf dem Substrat (1).

10. Verfahren nach Anspruch 9, **dadurch gekennzeichnet, dass** die Barriere (4) zumindest eine Ausnehmung (45) enthält.

11. Verfahren nach einem der Ansprüche 9 oder 10, **dadurch gekennzeichnet, dass** die erhabene Struktur (2) und/oder die Barriere (4) eine Längsausdehnung besitzen und der zur Implantation verwendete Ionenstrahl (3) unter einem Winkel von etwa 45° bis etwa 90° zur Längsausdehnung der erhabenen Struktur (2) und/oder der Barriere (4) einfällt.

12. Verfahren nach Anspruch 11, **dadurch gekennzeichnet, dass** der zur Implantation verwendete Ionenstrahl (3) unter
einem Winkel von etwa 45° bis etwa 85° oder
einem Winkel von etwa 45° bis etwa 80° oder
einem Winkel von etwa 60° bis etwa 80° oder
zur Längsausdehnung der erhabenen Struktur (2) und/oder der Barriere (4) einfällt.

13. Verfahren nach einem der Ansprüche 1 bis 12, **dadurch gekennzeichnet, dass** die erhabene Struktur (2) zumindest einen Mesa oder einen Cantilever enthält.

14. Verfahren nach Anspruch 13, **dadurch gekennzeichnet, dass** der Cantilever parallel zur ersten Seite (11) des Substrates (1) verläuft und/oder
dass der Cantilever innerhalb einer zur Substratebene parallelen Ebene liegt und/oder
dass das erste Ende (21) des Cantilevers über einen Verbindungssteg mit dem Substrat (1) verbunden ist und das gegenüberliegende zweite Ende (22) frei auskragt und/oder
dass der implantierte Teilbereich (25) an das zweite Ende (22) des Cantilevers angrenzt.
